# EUROPÄISCHE PATENTSCHRIFT

(11) **EP 3 350 356 B1**
(45) Veröffentlichungstag und Bekanntmachung des Hinweises auf die Patenterteilung: **24.08.2022**
(21) Anmeldenummer: 16763836.0
(22) Anmeldetag: 13.09.2016
(51) Int. Cl.: C23C 16/02, C23C 16/27

(54) **SCHNEIDPLATTE UND HERSTELLUNGSVERFAHREN**
CUTTING PLATE AND METHOD OF MANUFACTURING SAME
PLAQUETTE DE COUPE ET PROCEDE DE FABRICATION

(30) Priorität: 15.09.2015 EP 15185257
(43) Veröffentlichungstag der Anmeldung: 25.07.2018
(73) Patentinhaber: Hilti Aktiengesellschaft, 9494 Schaan (LI)
(72) Erfinder: SURBERG, Cord-Henrik, 6800 Feldkirch (AT); MASSLER, Orlaw, 9497 Triesenberg (LI); LEISCHNER, Matthias, 90475 Nürnberg (DE); ROSIWAL, Stefan, 96049 Bamberg (DE)
(74) Vertreter: Hilti Aktiengesellschaft Corporate Intellectual Property
(86) Internationale Anmeldenummer: PCT/EP2016/071491
(87) Internationale Veröffentlichungsnummer: WO 2017/046047

(56) Entgegenhaltungen:
- EP-A1- 0 614 998
- EP-A1- 2 832 899
- EP-A2- 0 166 708
- WO-A1-03/020997
- WO-A1-2008/116238
- DD-A1- 148 349
- DE-A1- 3 522 583
- DE-A1- 19 521 007
- DE-A1-102014 210 371
- DE-B3-102013 213 454
- DE-U1-202006 006 425
- US-A1- 2015 218 694

## Beschreibung

### GEBIET DER ERFINDUNG

Die vorliegende Erfindung betrifft ein Herstellungsverfahren für eine Schneidplatte gemäß dem Oberbegriff des Anspruchs 1 und eine Schneidplatte gemäß dem Oberbegriff des Anspruchs 3. Ein solches Verfahren und eine solche Schneidplatte sind aus dem Dokument DE 35 22 583 A1 bekannt.

### OFFENBARUNG DER ERFINDUNG

Die erfindungsgemäße Schneidplatte hat einen Grundkörper aus einem gesinterten Hartmetall. Auf einer Oberseite des Grundkörpers sind ein oder mehrere Zwischenschichten, welche eine Haftvermittlungsschicht aufweisen. Die Haftvermittlungsschicht ist aus einem borhaltigen Nitrid eines Übergangsmetalls der Gruppe IV, Gruppe V und Gruppe VI und enthält eine Vielzahl zu der Oberseite geneigt orientierter, lenticularer Plättchen. Eine auf der Haftvermittlungsschicht aufgewachsene Diamantschicht hat zu der Oberseite vertikal orientierte, Stängel-förmige Kristalle, deren Aspektverhältnis größer drei, vorzugsweise größer fünf ist.

Die borhaltige Plättchenstruktur ermöglicht ein stabiles Anbinden der Stängel-förmigen Kristalle der Diamantschicht. Trotz des großen Unterschieds in dem thermischen Ausdehnungskoeffizienten des Hartmetalls und der bei dicken Diamantschichten daraus entstehenden hohen Abkühleigenspannungen kommt es durch die mechanische Verklammerung mit der Diamantschicht mit der Plättchenstruktur und der guten chemischen Anbindung zu einer sehr guten Haftfestigkeit, welche sogar ein schlagende Belastung ohne Abplatzen der Diamantschicht zulässt.

Eine Ausgestaltung sieht vor, dass die Oberseite des Grundkörpers sehr rau auf einer Skala von 1 mm ist. Eine gemittelte Rautiefe Rz nach DIN ISO 4287 definiert für eine Messstrecke mit einer Länge von 800 µm beträgt wenigstens 5 µm, vorzugsweise höchstens 12 µm. Ausgestaltungen der Erfindung sehen vor, dass die Stängel-förmigen Kristalle zueinander parallel sein können, eine Höhe der Stängel-förmigen Kristalle gleich einer Höhe der Diamantschicht sein kann, die Stängel-förmigen Kristalle über Korngrenzen aneinander angrenzen können, die Stängel-förmigen Kristalle etwa den gleichen Durchmesser aufweisen.

Ein erfindungsgemäßes Herstellungsverfahren für eine Schneidplatte (12), insbesondere eine Schneidplatte (12) für eine Kernbohrkrone (2) sieht folgende Schritte vor. Ein Grundkörper wird aus einem Hartmetall gesintert und geformt. Ein oder mehreren Zwischenschichten (25) einschließlich einer Haftvermittlungsschicht (26) werden auf eine Oberseite (23) des Grundkörpers (22) mittels eines Gasabscheideverfahrens (CVD) abgeschieden. Das Abscheiden der Haftvermittlungsschicht (26) aus bohrhaltigen Nitriden von Übergangsmetallen umfasst die Teilschritte: Abscheiden von Nitriden eines oder mehrerer Übergangsmetalle aus der Gruppe IV, Gruppe V und Gruppe VI des Periodensystems bei einer Temperatur zwischen 950°C und 1100°C zum Ausbilden einer Vielzahl zu der Oberseite (23) geneigt orientierter Plättchen (31), und Abscheiden eines Borids und/oder Bornitrids der ein oder mehreren Übergangsmetalle. Ein Aufwachsen der Diamantschicht (24) auf der Haftvermittlungsschicht (26) umfasst die Teilschritte: Bekeimen der Haftvermittlungsschicht (26) mit Diamantstaub und Aufwachsen von Stängel-förmigen Diamanten aus der Gasphase auf der Haftvermittlungsschicht (26).

Die borhaltige und plättchen-förmige Haftvermittlungsschicht begünstigt das stabile chemische Anwachsen der Stengel-förmigen Kristalle an die Plättchenoberfläche unter Anderem durch in-situ Ausbildung von freien Kohlenstoffbindungen während des Austausches von Bor mit Kohlenstoff aus der Gasphase.

Die Oberseite des Grundkörpers kann vor dem Aufbringen der Zwischenschichten aufgeraut werden, bis sich eine hohe Rauheit einstellt. Eine gemittelte Rautiefe Rz definiert für eine Messstrecke mit einer Länge von 800 µm beträgt wenigstens 5 µm, vorzugsweise höchstens 12 µm.

### KURZE BESCHREIBUNG DER FIGUREN

Die nachfolgende Beschreibung erläutert die Erfindung anhand von exemplarischen Ausführungsformen und Figuren. In den Figuren zeigen:
- Fig. 1: eine ständergeführte Kernbohrmaschine
- Fig. 2: eine Teilansicht einer Kernbohrkrone
- Fig. 3: einen schematischen Querschnitt durch eine Schneidplatte der Kernbohrkrone
- Fig. 4: einen Querschliff durch eine Schneidplatte
- Fig. 5: den Ausschnitt V aus Fig. 4
- Fig. 6: eine Draufsicht auf eine Plättchenstruktur der Haftvermittlungsschicht
- Fig. 7: ein vergrößerter Ausschnitt von Fig. 6
- Fig. 8: eine Draufsicht auf die dünnstängelige Diamantschicht
- Fig. 9: eine Draufsicht auf die dickstängelige Diamantschicht

Gleiche oder funktionsgleiche Elemente werden durch gleiche Bezugszeichen in den Figuren indiziert, soweit nicht anders angegeben.

### AUSFÜHRUNGSFORMEN DER ERFINDUNG

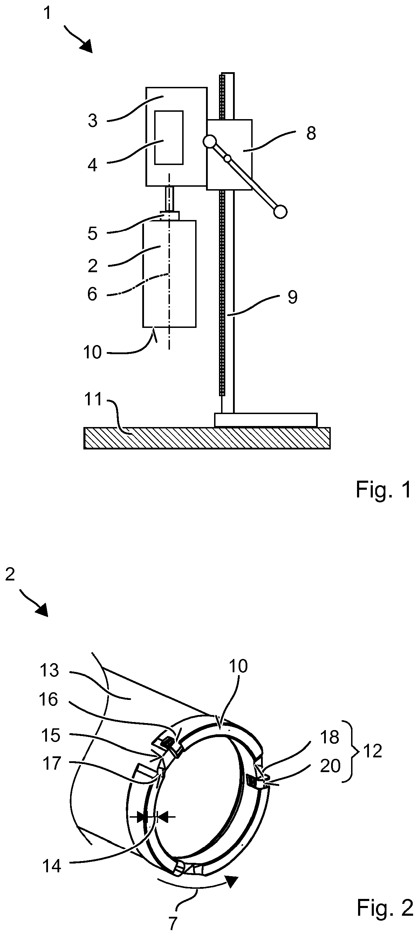

Fig. 1 zeigt beispielhaft eine ständergeführte Kernbohrmaschine **1** mit einer Kernbohrkrone **2.** Die Kernbohrmaschine **1** hat eine Antriebseinheit **3** mit einem Motor **4.** Die Antriebseinheit **3** kann neben dem Motor **4** unter Anderem ein Getriebe und eine Sicherheitskupplung enthalten. Der Anwender kann den Motor **4** durch einen Betriebsschalter einschalten und ausschalten. Die Antriebseinheit **3** dreht einen Werkzeughalter **5** um eine Arbeitsachse **6.** Die Kernbohrkrone **2** kann, koaxial zu der Arbeitsachse **6** ausgerichtet, in den Werkzeughalter **5** eingehängt und verriegelt werden. Der Werkzeughalter **5** überträgt das Drehmoment der Antriebseinheit **3** auf die Kernbohrkrone **2,** welche sich somit um die Arbeitsachse **6** in einer Umlaufrichtung **7** dreht. Die Antriebseinheit **3** ist an einem Schlitten **8** aufgehängt, der parallel zu der Arbeitsachse **6** entlang einer Ständers **9** verfahrbar ist. Beispielsweise kann der Anwender mittels einer Kurbel den Schlitten **8** verschieben, alternativ kann ein Motor mit geeigneter Steuerung den Schlitten **8** bewegen. Die schneidende Stirnfläche **10** der Kernbohrkrone **2** wird mit einem konstanten Anpressdruck an einen zu bearbeitenden Untergrund **11** angepresst. Die Kernbohrkrone **2** hat mehrere in die Stirnfläche **10** eingesetzte Schneidplatten **12,** die einen kreisförmigen Schlitz in den Untergrund **11** schneiden. Die Schneidplatten **12** sind für die Bearbeitung von mineralischen Bauwerkstoffen, insbesondere für stahlarmierten Beton, ausgelegt.

Fig. 2 zeigt eine beispielhafte Stirnfläche **10** der Kernbohrkrone **2.** Die Kernbohrkrone **2** hat ein zylindrisches Rohr **13,** das in der ringförmigen Stirnfläche **10** endet. Der Durchmesser des Rohrs **13** und der Stirnfläche **10** variiert nach Anwendungsgebiet. Typische Durchmesser liegen im Bereich von 5 cm bis 1 m. Die Wandstärke **14** des Rohrs **13** ist typischerweise zwischen 4 mm und 8 mm.

Die Stirnfläche **10** ist durch mehrere in Umlaufrichtung **7** angeordneten Aussparungen **15** unterbrochen. Die Aussparungen **15** haben in Umlaufrichtung **7** aufeinanderfolgend eine von der Stirnfläche **10** abfallende, steile Flanke **16** und eine zu der Stirnfläche **10** hin ansteigende, flache Flanke **17.** Die steile Flanke **16** ist beispielsweise parallel oder um weniger als 10 Gad zu der Arbeitsachse **6** geneigt. Die flache Flanke **17** verläuft mit einer mittleren Steigung von weniger als 45 Grad, z.B. von mehr als 30 Grad, und vorzugsweise wenigstens 10 Grad von der steilen Flanke **16** bis zu der Stirnfläche **10.**

Die Schneidplatte **12** ist in die Aussparung **15** eingesetzt. Die Schneidfläche **18** der Schneidplatte **12** weist in die Umlaufrichtung **7,** vorzugsweise ist die Schneidfläche **18** senkrecht zu der Umlaufrichtung **7** orientiert. Die Schneidplatte **12** hat einen weitgehend prismatischen Aufbau, d.h. eine Rückseite **19** der Schneidplatte **12** hat die gleiche oder eine geringfügig kleinere Fläche wie die Schneidfläche **18.** Die umlaufende Mantelfläche **20** der Schneidplatte **12** ist senkrecht oder näherungsweise senkrecht zu der Schneidfläche **18.** Die Mantelfläche **20** der beispielhaften Schneidplatte **12** ist um wenigstens 75 Grad, vorzugsweise wenigstens 80 Grad, beispielsweise höchstens 85 Grad, gegenüber der Schneidfläche **18** geneigt.

Die Rückseite **19** der Schneidplatte **12** liegt flächig an der steilen Flanke **16** der Aussparung **15** an. Die Schneidplatte **12** liegt vorzugsweise mit wenigstens 75 % ihrer Rückseite an dem Rohr **13** an, um die Schneidplatte **12** bei einwirkenden Stöße während des Bearbeitens von Bauwerkstoffen, insbesondere beim plötzlichen Eingreifen in Armierungseisen, abzustützen. Die Rückseite **19** kann mit dem Rohr **13** verlötet oder verschweißt sein. Die in Umlaufrichtung **7** weisende Schneidfläche **18** liegt weitgehend frei. Die flache Flanke **16** und die Schneidfläche **18** begrenzen einen Volumen, das gegenüber der Stirnfläche **10** zurückgesetzt ist. Die Schneidplatte **12** steht läng der Arbeitsachse **6** über die Stirnfläche **10** hinaus. Der axiale Überstand liegt im Bereich von 0,1 mm bis 1 mm. Eine Breite **21** der Schneidplatte **12** kann größer als die Wandstärke **14** des Rohrs **13** sein, wodurch die Schneidplatte **12** in radialer Richtung, vorzugsweise nach innen zu der Arbeitsachse **6** und nach außen von der Arbeitsachse **6** weg, übersteht. Der radiale Überstand liegt vorzugsweise im Bereich zwischen 0,1 mm und 0,5 mm.

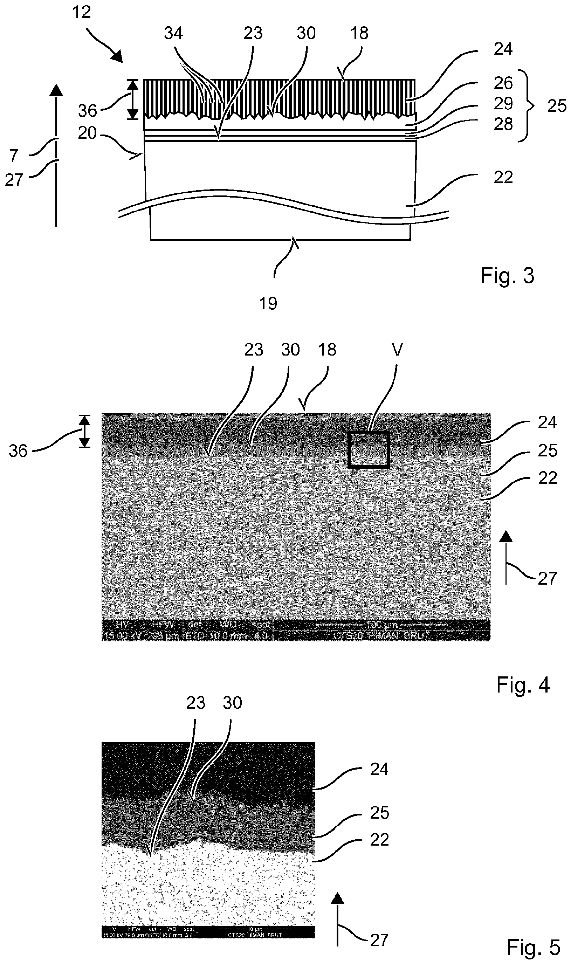

Die Schneidplatte **12** hat einen Grundkörper **22** und auf einer Oberseite **23** des Grundkörpers **22** eine Diamantschicht **24,** welche die Schneidfläche **18** bildet (Fig. 3). Ein oder mehrere Zwischenschichten **25,** beispielhaft drei Zwischenschichten **25,** sind zwischen dem Grundkörper **22** und der Diamantschicht **24** angeordnet. Die Zwischenschichten **25** ermöglichen prozesstechnisch die Diamantschicht **24** abzuscheiden und auch eine robuste, insbesondere eine stoßfeste Anbindung der Diamantschicht **24** an den Grundkörper **22.** Dies gilt insbesondere für die an die Diamantschicht **24** angrenzende Zwischenschicht, welche nachfolgend als Haftvermittlungsschicht **26** bezeichnet wird. Die Zwischenschichten **25,** einschließlich der Haftvermittlungsschicht **26,** und die Diamantschicht **24** sind nacheinander in einer Wachstumsrichtung **27** auf den Grundkörper **22** abgeschieden. Die Schneidplatte **12** wird vorzugsweise derart in das Werkzeug eingesetzt, dass deren Arbeitsrichtung, hier die Umlaufrichtung **7,** parallel zu der Wachstumsrichtung **27** ist.

Der beispielhafte Grundkörper **22** bildet den größten Teil der Schneidplatte **12** und legt die Form und Abmessungen der Schneidplatte **12** fest, insbesondere der Rückseite **19** und der Mantelfläche **20.** Der Grundkörper **22** gibt der Schneidplatte **12** die notwendige mechanische Stabilität, insbesondere schützt der Grundkörper **22** die Diamantschicht **24** vor Biege- und Scherkräften beim Bearbeiten von mineralischen Bauwerkstoffen. Zudem ist der Grundkörper **22** ausreichend hart, um ein Durchbiegen der Diamantschicht **24** beim Bearbeiten von mineralischen Bauwerkstoffen zu verhindern.

Der Grundkörper **22** besteht weitgehend aus einem gesinterten Hartmetall. Ein bevorzugtes Hartmetall beinhaltet Körner aus Wolframkarbid, welche in einer metallischen Matrix aus einer Kobalt-basierten oder Nickel-basierten Legierung eingebettet sind. Der Volumenanteil der Körner ist größer als 80 Gewischtsprozent (Gew.-%), vorzugsweise größer oder gleich 90 Gew.-%, und geringer als 95 Gew.-%. Die Körner sind von einem ultrafeinen oder submicro Grad; die mittlere Korngröße liegt etwa zwischen 0,2 µm und 1,0 µm. Die metallische Matrix besteht beispielsweise aus Kobalt oder einer Kobaltbasierten Legierung. Die Körner des Hartmetalls können neben oder anstelle von Wolframkarbid aus anderen Karbiden und/oder Karbonitriden von Übergangsmetallen der Gruppe IV, Gruppe V und der Gruppe VI des chemischen Periodensystems bestehen. Insbesondere können dem Wolframkarbid Körner aus Titannitrid, Titankarbonitrid, Tantalkarbid beigemengt sein, die sich durch ihre hohe Härte auszeichnen.

Der Volumenanteil der metallischen Matrix ist nahe der Oberseite **23** nicht reduziert. Insbesondere ist die Kobalt-haltige Legierung nicht durch ätzende Verfahren herausgelöst, wodurch die Oberseite **23** porös wird. Das Hartmetall ist an der Oberseite **23** gleichermaßen verdichtet, wie innerhalb des Grundkörpers **22.** Der Volumenanteil der metallischen Matrix ist vorzugsweise in der Wachstumsrichtung **27** konstant.

Die Oberseite **23** des Grundkörpers **22** ist aufgeraut. Die Rauheit kann durch den arithmetischen Mittenrauwert Ra und die gemittelte Rautiefe Rz angegeben werden. Die Rauheit des Grundkörpers **22** wird über eine Messstrecke bestimmt, deren Länge auf 800 µm festgelegt ist. Bei dem arithmetischen Mittenrauwert Ra wird das arithmetische Mittel der betragsmäßigen Abweichung der punktuellen Höhe der Oberseite **23** innerhalb der Messstrecke von einer mittleren Höhe auf der Messstrecke ermittelt. Der arithmetische Mittenrauwert Ra der Oberseite **23** ist größer als 0,7 µm, vorzugsweise größer 1,0 µm, und geringer als 2,3 µm, vorzugsweise geringer als 1,9 µm. Die gemittelte Rautiefe Rz ist das arithmetische Mittel der Differenz der Höhe der größten Profilspitzen und der Tiefe des größten Profiltals innerhalb von fünf der Messstrecken. Die Oberseite **23** ist vorzugsweise sehr schroff, daher ergibt sich eine deutlich höhere gemittelte Rautiefe Rz gegenüber dem arithmetischen Mittenrauwert Ra. Die gemittelte Rautiefe Rz liegt im Bereich zwischen 5 µm und 13 µm, vorzugsweise größer als 6 µm, vorzugsweise geringer als 9 µm. Die Rauheit kann durch ein geeignetes Partikelstrahlverfahren, d.h. Druckluftstrahlen mit einem körnigen Abrasivmittel, der Oberseite **23** eingestellt werden.

Eine dünne Barriereschicht **28** kann unmittelbar auf dem Hartmetall an der Oberseite **23** des Grundkörpers **22** aufgewachsen sein. Die Barriereschicht **28** hat eine Stärke zwischen 0,1 µm und 2,0 µm und deckt die Oberseite **23** vollständig ab. Die Barriereschicht **28** soll eine Diffusionsbarriere für Kohlenstoff darstellen, um ein Austreten des Kohlenstoffs aus dem Hartmetall zu unterbinden. Die Barriereschicht **28** soll gut an dem Hartmetall haften und die gesamte Härte des Bauteils möglichst wenig reduzieren. Als besonders geeignet erweist sich hierfür Titannitrid, welches bereits bei einer geringen Schichtdicke von 0,3 µm eine ausreichend Diffusionsbarriere ausbildet. Zudem haftet Titannitrid gut auf Wolframkarbidbasierten Hartmetallen.

Eine Kohlenstoff-haltige Promotionsschicht **29** kann auf der Barriereschicht **28** aus der Gasphase aufgewachsen. Die Promotionsschicht **29** ist beispielsweise zwischen 0,5 µm und 3 µm stark. Die bevorzugte Promotionsschicht **29** besteht aus einem Karbid und/oder Karbonitrid des Übergangsmetalls der Barriereschicht **28,** z.B. Titankarbid bzw. Titankarbonitrid. Anstelle oder zusätzlich zu dem Übergangsmetall der Barriereschicht **28** können die Karbide und/oder Karbonitride von Übergangsmetallen der Gruppe IV, Gruppe V und Gruppe VI abgeschieden werden.

Die Zwischenschichten **25** enthalten eine Haftvermittlungsschicht **26,** welche das Aufwachsen der Diamanten in gewünschter Weise ermöglicht. Die Haftvermittlungsschicht **26** hat eine hohe Mikrorauheit an ihrer der Diamantschicht **24** zugewandten Kontaktseite **30.** Die Rauheit ergibt sich durch eine Struktur von im Wesentlichen vertikal zu der Oberseite **23** orientierten, dünnen Plättchen **31.** Die Plättchen **31** bestehen weitgehend aus einem oder mehreren Nitriden der Übergangsmetalle der Gruppe IV, Gruppe V und Gruppe VI. Das Übergangsmetall ist vorzugsweise Titan, insbesondere wenn die vorhergehenden Zwischenschichten **25** Titan-basiert sind. Die Plättchen **31** enthalten vorzugsweise keinen Kohlenstoff und kein Karbid. Das molare Verhältnis von Kohlenstoff zu Stickstoff kann in den Plättchen **31** deutlich geringer als eins zu zwanzig sein und können auf Verunreinigungen in der Reaktionskammer oder Diffusionsprozesse aus der Diamantabscheidung zurückzuführen sein. Die schmalen Seiten oder Kanten **32** der Plättchen **31,** welche zu der Diamantschicht **24** weisen, enthalten vorzugsweise Bor. Das Bor kann als Borid des Übergangsmetalls, Bornitrid des Übergangsmetalls und/oder atomares Bor an Gitterfehlstellen vorliegen. Vorzugsweise ist nur eine dünne Grenzschicht der Plättchen **32,** z.B. von weniger als 100 nm Stärke, borhaltig.. Die Haftvermittlungsschicht **26** bindet die Diamantschicht **24** chemisch und mechanisch an das gesinterte Hartmetall des Grundkörpers **22** an.

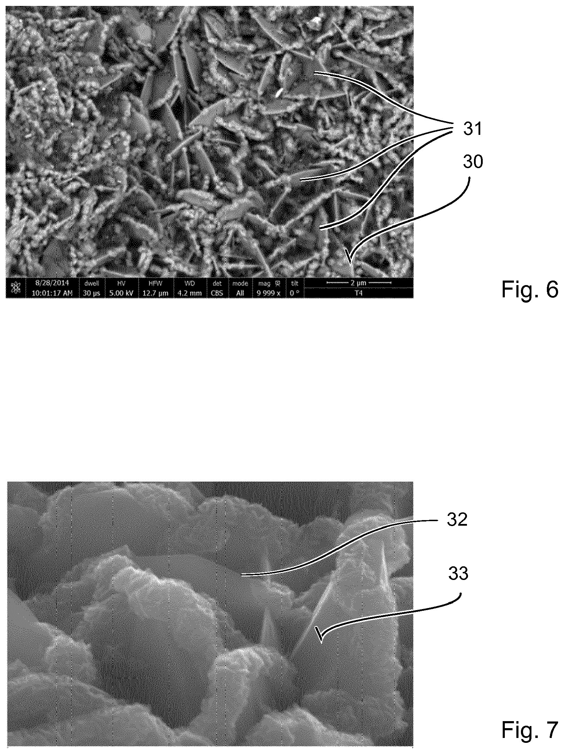

Die Plättchen **31** bilden eine lenticulare Struktur mit sehr steilen Hängen. Die Plättchen **31** haben jeweils zwei gegenüberliegende weitgehend identischen Seitenflächen **33,** die parallel oder leicht zueinander geneigt sind. Die Seitenflächen sind vertikal oder geneigt zu der mittleren Oberseite **23** des Grundkörpers **22** orientiert. Die Neigung der Seitenflächen **33** ist größer als 60 Grad, vorzugsweise größer als 80 Grad. Eine Dicke des Plättchens ist durch den Abstand der Seitenflächen vorgegeben. Die Dicke ist deutlich geringer als die Länge und Höhe der Seitenflächen **33** bzw. des Plättchens **31,** vorzugsweise ist die Höhe wenigstens doppelt, z.B. zehnfach, so groß wie die Breite. Die Länge der Plättchen **31** kann gleich oder größer als die Höhe sein. Die Plättchen **31** sind im Mittel zwischen 1 µm und 5 µm lang, 0,5 µm und 2 µm hoch und deutlich unter 0,7 µm breit. Fig. 6 zeigt eine Draufsicht auf die Plättchen **31;** die körnige Struktur auf den Kanten **32** sind Borverbindungen. Fig. 7 ist eine vergrößere Darstellung von Fig. 6. Die Plättchen **31** haben schmale freiliegende Kanten **32,** die in Wachstumsrichtung **27,** d.h. zu der Diamantschicht **24** hin, weisen. Die Plättchen **31** bedecken weitgehend die gesamte Kontaktseite **30,** vorzugsweise wenigstens 75 % derer Oberfläche. Die Kanten **32** der Plättchen **31** bilden eine erhabene netzförmige Struktur. Die Plättchen **31** sind ohne erkennbare Regelmäßigkeit in unterschiedliche Richtungen in der Ebene der Haftvermittlungsschicht **26** orientiert. Die Plättchen **31** können unter verschiedenen Winkel aneinandergrenzen, die Winkel können beispielsweise im Bereich zwischen 20 Grad und 90 Grad liegen.

Die Diamantschicht **24** ist auf der Haftvermittlungsschicht **26,** insbesondere den Plättchen **31** abgeschieden. Die borhaltigen Kanten **32** der Plättchen **31** begünstigen die chemische Anbindung von Diamant auf der Haftvermittlungsschicht **26.** Die frei orientierten Plättchen **31** erhöhen die Haftfestigkeit zwischen der Diamantschicht **24** und dem Grundkörper **22.**

Die Diamantschicht **24** besteht aus zu mehr als 90% aus vielen einzelnen stabförmigen Kristallen, nachfolgend als Stängel **34** bezeichnet, welche sich durch Auswachsen der Nanodiamant-Keime bildet. Die erste Nanodiamantkeimschicht ist fest mit der Haftvermittlungsschicht **26** chemisch und mechanisch verankert. Die Stängel **34** sind vertikal zu der Kontaktseite **30** der Haftvermittlungsschicht **26,** d.h. der Oberseite **23,** orientiert. Die Stängel **34** grenzen aneinander an. Benachbarte Stängel sind durch zwischen ihnen ausgebildete Korngrenzflächen **35** getrennt. Die Stängel **34** erstrecken sich in der Regel von der Nanodiamantkeimschicht **26** bis zu der Schneidfläche **18,** d.h. eine Höhe der Stängel **34** ist gleich der Höhe **36** der Diamantschicht **24.** Die Diamantschicht **24** erweist sich als äußert belastbar in Hinblick auf Stöße. Die Diamantschicht **24** aus den Stängeln erweist sich als mechanisch stabil und robust gegenüber statischen und dynamischen Belastungen aus unterschiedlichen Richtungen und Schlägen. Die Diamantschicht **24** weist trotz der Stängelform eine sehr hohe Härte auf, welche für das Bearbeiten von harten mineralischen Werkstoffen notwendig ist.

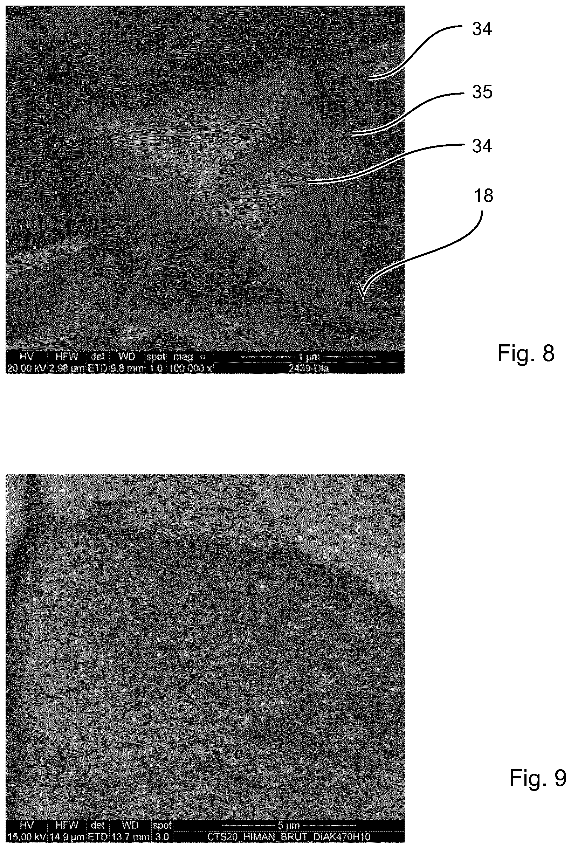

Die Stängel **34** sind vorzugsweise sehr dünn. Das Aspektverhältnis der Stängel, d.h. das Verhältnis der Höhe zu dem Durchmesser ist größer drei, vorzugsweise größer fünf. Die dünnen Stängel erweisen sich als robuster gegenüber Schlagbelastungen. Der Durchmesser wird in einer Ebene parallel zu der Oberseite **23** und die Höhe senkrecht zu der Oberseite **23** bestimmt. Die dünnen Stängel **34** haben vorzugsweise eine Höhe von mehr als 10 µm, beispielsweise mehr als 20 µm, mehr als 40 µm. Eine Höhe von bis zu 100 µm kann realisiert werden. Die Stängel **34** erstrecken sich über die gesamte Höhe **36** der Diamantschicht **24.** Der Durchmesser der Stängel liegt unter 10 µm, bevorzugt ist jedoch ein deutlich geringerer Durchmesser von unter 2 µm (Fig. 9), weniger als 100 nm, und wenigstens 10nm (Fig. 8). Die Stabilität der Stängel ergibt sich durch das Abstützen an benachbarten Stängel und der chemischen Bindung.

Die Stängel **34** der Diamantschicht **24** sind in ihren Abmessungen und der Kristallorientierung längs Wachstumsrichtung **27** über die gesamte Diamantschicht **24** homogen. Beispielsweise weicht der Durchmesser von etwa 80 % der Stängel **34** um weniger als 50 % von dem mittleren Durchmesser der Stängel **34** ab. Die Stängel **34** haben ein dem Diamant entsprechendes kubisches Kristallgitter. Eine Kristallachse der Stängel **34** ist längs der Höhe **36** der Stängel **34** orientiert. Diese vertikale Kristallachse kann beispielsweise die [110]-Kristallachse oder die [111]-Kristallachse sein. Die Stängel **34** der Diamantschicht **24** haben weitgehend alle die gleiche vertikale Kristallachse. Die Kristallorientierung der Stängel **34** sind somit längs der Wachstumsrichtung **27** oder Höhe der Stängel **34** zueinander parallel.

Die Herstellung einer Diamantschicht **24** auf einem gesinterten Hartmetall wird beispielhaft anhand der Herstellung einer Schneidplatte **12** erläutert.

Der Grundkörper **22** wird aus einem Grünling geformt. Der Grünling enthält ein Gemisch aus Körnern und einem metallischen Binder. Die Körner haben einen Anteil von wenigstens 60 Vol.-%, vorzugsweise wenigstens 90 Vol.-%, maximal 94 Vol.-% an dem Gemisch. Die Körner haben eine Größe von etwa zwischen 0,5 µm und 5,0 µm. Die beispielhaften Körner bestehen beispielsweise aus Wolframkarbid. Das Wolframkarbid kann teilweise oder vollständig durch andere Karbide, Nitride und/oder Karbonitride von Übergangsmetallen. Insbesondere können dem Wolframkarbid Körner aus Titannitrid, Titankarbonitrid, Tantalkarbid beigemengt sein, die sich durch ihre hohe Härte auszeichnen. Der metallische Binder ist vorzugsweise Kobalt, Nickel oder eine Legierung aus Kobalt und Nickel. Der Grünling wird gepresst und in eine dem Grundkörper **22** entsprechende Form gebracht. Die Form berücksichtigt den Schrumpfungsvorgang beim Sintern. Anschließend wird der Grünling zwischen 1100 Grad Celsius (°C) und 1350 °C gesintert.

Der gesinterte Grundkörper **22** kann mechanisch nachbearbeitet werden. Die Oberseite **23** des Grundkörpers **22** wird gereinigt, um sie für die Abscheidung der Haftvermittlungsschicht **26** vorzubereiten. Die Oberseite **23** kann insbesondere sand-gestrahlt werden, beispielsweise mit Siliziumkarbid. Die Körner des Siliziumkarbids können beispielsweise im Mittel 180 µm groß sein. Die Oberseite **23** wird hierdurch nicht nur von Oxidschichten und sonstigen Verunreinigungen gesäubert, sondern erhält vorzugsweise eine gewünschte Rauheit.

Beispiel 1 direkte Abscheidung der Haftvermittlungsschicht **26** auf dem Grundkörper **22** mit nachfolgendem Wachstum einer Diamantschicht **24** mit relativ breiten stabförmigen Diamantkristallen

Die Haftvermittlungsschicht **26** wird auf dem Grundkörper **22** aus der Gasphase (CVD-Verfahren) abgeschieden. Das beispielhafte Verfahren scheidet die Plättchen **31** der Haftvermittlungsschicht **26** aus Nitriden eines Übergangsmetalls unmittelbar auf dem Hartmetall des Grundkörpers **22** ab. Die Abscheidung unterteilt sich in zwei Phasen. In einer ersten Phase werden, vorzugsweise reine, Nitrid-Plättchen **31** abschieden. In einer zweiten Phase wird borhaltiges Nitrid abgeschieden. Die Abscheidung wird beispielhaft für Plättchen **31** aus Titannitrid beschrieben.

Die Atmosphäre in einem Reaktor setzt sich für die erste Phase aus Titan(IV)-chlorid (TiCI4), Stickstoff (N2) und Wasserstoff (H2) zusammen. Die Atmosphäre ist insbesondere frei von kohlenstoffhaltigen Gasen. Titan(IV)-chlorid hat einen Volumenanteil zwischen 1 Vol.-% und 5 Vol.-%, vorzugsweise einen Anteil zwischen 2 Vol.-% und3 Vol.-%. Wasserstoff hat beispielsweise einen Volumenanteil zwischen 50 Vol.-% und 70 Vol.-%, Stickstoff hat beispielsweise einen Volumenanteil zwischen 30 Vol.-% und 45 Vol.-%. Stickstoff wird in der Gasphase in großem Überschuss zu dem Titan(IV)-chlorid angeboten. In einem Beispiel sind die relativen Anteile: 160 Volumeneinheiten Wasserstoff, 105 Volumeneinheiten Stickstoff und 7 Volumeneinheiten Titan(IV)-chlorid. Die Temperatur in der Reaktionskammer ist gegenüber sonstigen Abscheideverfahren recht hoch eingestellt. Für das Wachstum der Plättchenstruktur erweisen sich Temperaturen von mehr als 950 Grad Celsius (°C) als vorteilhaft, wenn nicht sogar als notwendig. Die Temperatur kann während der Abscheidung konstant gehalten werden. Temperaturen oberhalb von 1100°C erweisen sich als nachteilig, da sich das Grundkörper verändert. Für das obige Beispiel ist eine Temperatur von 1000°C eingestellt. Der Druck in der Reaktionskammer liegt beispielsweise im Bereich zwischen 550 mbar und 650 mbar. Zu obigem Beispiel ist der Druck auf 600 mbar eingestellt. Mit den beispielhaften Parametern lassen sich Plättchen **31** mit einer mittleren Höhe zwischen 3 µm und 4 µm herstellen. Die Breite der Plättchen **31** liegt unterhalb von 0,2 µm. Die Wachstumsrate liegt im Bereich von 1 bis 5 µm pro Stunde. Die erste Phase wird beispielsweise nach 50 min beendet.

Die Zusammensetzung der Atmosphäre wird in dem Reaktor für die zweite Phase etwas geändert, indem zu Titan(IV)-chlorid (TiCI4), Stickstoff (N2) und Wasserstoff (H2) noch Bortrichlorid (BCl3) eingeleitet wird. Das Borchlorid hat einen Anteil von 0,1 % und 0,4 %, die Gasanteile von TiCl4, N2 und H2 bleiben gegenüber der ersten Phase unverändert. Ebenso werden die weiteren Prozessparameter, wie Druck und Temperatur, der ersten Phase beibehalten. Die Plättchen **31** aus Titannitrid wachsen weiter. An den Kanten **32** der Plättchen **31** scheidet sich Kristalle aus Titandiborid Titanboridverbindungen ab, hingegen im Wesentlich nicht auf den Seitenflächen **33** der Plättchen **31.** Die Seitenflächen **33** bleiben somit aus reinem Titannitrid. Die Abscheidung wird nach 10 Minuten beendet. Die Schichtdicke der Titanboridverbindungen liegt im Bereich zwischen 10 nm und 200 nm.

Der mit der Haftvermittlungsschicht **26** beschichtete Grundkörper **22** wird in einer weiteren Gasphasenabscheidung (CVD-Verfahren) mit der Diamantschicht **24** beschichtet. Vor der Beschichtung werden Keimlinge für die Stängel-förmigen Kristalle auf der Haftvermittlungsschicht **26** aufgebracht. Als Keimling eignet sich Diamantstaub. Der Diamantstaub enthält Diamantkristalle mit einem Durchmesser zwischen 4 nm bis 50 nm. Die Keimlinge können beispielsweise in einer Suspension aufgesprüht werden.

Auf den mit den Kristallisationskeimen versehenen Grundkörper **22** wird in einem zweiten Reaktor die Diamantschicht **24** aus der Gasphase abgeschieden. Die Atmosphäre in dem Reaktor besteht aus Methan und Wasserstoff. Der Methangehalt liegt bei 0,8 Vol.-% und 1,6 Vol.-%, vorzugsweise höher 1,0 Vol.-%, vorzugsweise geringer als 1,4 Vol.-%, in einem Beispiel bei 1,2 Vol.-% Der Druck in der Reaktionskammer ist gering, vorzugsweise zwischen 2 mbar und 20 mbar, in dem Beispiel 5 mbar. Die Abscheidung erfolgt bei einer Temperatur zwischen 700 °C und 850 °C, z.B. 770°C. Die Diamantkristalle wachsen ausgehend von den Kristallisationskeimen. Das Titandiborid wird für das Wachstum geopfert, indem die Titan-Bor-Bindung aufgebrochen und das Bor zumindest teilweise freigesetzt wird und sich freie Oberflächenbindungen (dangling bonds) bilden. Das Kristallwachstum ist an der Oberkante der Plättchen begünstigt, wodurch die Diamantkristalle dort schneller wachsen. Das Wachstum beginnt somit hauptsächlich auf den Kanten **32** der Plättchen **31.** Die Diamantkristalle wachsen soweit in die Höhe und Breite bis ihre Ausdehnung durch einen anderen Diamantkristall behindert wird. Nachfolgend wachsen die Diamantkristalle im Wesentlichen nur noch in die Höhe, wodurch sich der Stängelförmige Kristall ergibt. Der mittlere Durchmesser liegt bei den Wachstumsbedingungen, insbesondere der Konzentration von Methan, im Mittel zwischen 1 µm und 10 µm, beispielsweise bei 4 µm. Die Abscheidungsrate liegt zwischen 0,1 und 0,5 µm pro Stunde. In 160 Stunden konnte eine Schichtdicke von 43 µm erreicht werden.

Beispiel 2 direkte Abscheidung der Haftvermittlungsschicht **26** auf dem Grundkörper **22** mit nachfolgendem Wachstum einer Diamantschicht **24** mit relativ breiten stabförmigen Diamantkristallen

Das zweite Beispiel unterscheidet sich zu dem ersten Beispiel darin, dass das plättchenförmige Titannitrid in drei Phasen abgeschieden wird. Der Grundkörper **22** wird in gleicher Weise wie in Beispiel 1 vorbereitet.

Eine erste Schicht aus Titannitrid wird auf dem Hartmetall aus der Gasphase (CVD-Verfahren) abgeschieden. Die Atmosphäre in einem Reaktor setzt sich für die erste Phase aus Titan(IV)-chlorid (TiCI4), Stickstoff (N2) und Wasserstoff (H2) zusammen. Die Atmosphäre ist insbesondere frei von kohlenstoffhaltigen Gasen. Titan(IV)-chlorid hat einen Volumenanteil zwischen 1 Vol.-% und Vol.-%, z.B. 1,2 Vol.-%. Wasserstoff hat beispielsweise einen Volumenanteil zwischen 50 Vol.-% und 70 Vol.-%, Stickstoff hat beispielsweise einen Volumenanteil zwischen 30 Vol.-% und 45 Vol.-%. Stickstoff wird in der Gasphase in sehr großem Überschuss zu dem Titan(IV)-chlorid angeboten. In einem Beispiel sind die relativen Anteile: 170 Volumeneinheiten Wasserstoff, 100 Volumeneinheiten Stickstoff und 3 Volumeneinheiten Titan(IV)-chlorid. Die Temperatur in der Reaktionskammer liegt zwischen 750 Grad Celsius (°C) und 850°C, z.B. 800°C. Der Druck in der Reaktionskammer liegt beispielsweise im Bereich zwischen 550 mbar und 650 mbar. Bei obigem Beispiel ist der Druck auf 600 mbar eingestellt. Das Wachstum mit dem geringen Anteil Titan-haltigem Gases wird für etwa 60 Minuten bis 90 Minuten durchgeführt, um eine etwa 0,1 µm bis0,5 µm dicke Schicht zu erhalten. Die Schicht ist aufgrund des geringen Wachstums weitgehend homogen ohne Plättchenstruktur.

Der Anteil von Titan(IV)-chlorid wird auf einen Volumenanteil zwischen 1,5 Vol.-% und 7 Vol.%, vorzugsweise einen Anteil zwischen 2 Vol.-% und 3 Vol.-% erhöht. Wasserstoff hat beispielsweise einen Volumenanteil zwischen 50 Vol.-% und 70 Vol.-%, Stickstoff hat beispielsweise einen Volumenanteil zwischen 30 Vol.-% und 45 Vol.-%. Die relativen Anteile sind beispielsweise 160 Volumeneinheiten Wasserstoff, 105 Volumeneinheiten Stickstoff und 7 Volumeneinheiten Titan(IV)-chlorid. Die Temperatur in der Reaktionskammer und der Druck werden beibehalten. Mit den beispielhaften Parametern lassen sich Plättchen **31** mit einer mittleren Höhe zwischen 3 µm und 4 µm herstellen. Die Breite der Plättchen **31** liegt unterhalb von 0,2 µm. Die Wachstumsrate liegt im Bereich von 5 µm pro Stunde. Die Phase wird beispielsweise nach 50 min beendet.

Für die Borierung der Kanten **32** wird die Zusammensetzung der Atmosphäre geändert, indem zu Titan(IV)-chlorid (TiCI4), Stickstoff (N2) und Wasserstoff (H2) noch Bortrichlorid (BCl3) eingeleitet wird. Das Borchlorid hat einen Anteil von 0,1 Vol.-% und 0,4 Vol.-%, z.B. 0,2 Vol.-% die Gasanteile von TiCl4, N2 und H2 bleiben gegenüber der vorhergehenden Phase unverändert. Ebenso werden die weiteren Prozessparameter, wie Druck und Temperatur beibehalten. Die Plättchen **31** aus Titannitrid wachsen weiter. An den Kanten **32** der Plättchen **31** scheiden sich Kristalle aus Titanboridverbindungen ab, hingegen im Wesentlich nicht auf den Seitenflächen **33** der Plättchen **31.** Die Seitenflächen **33** bleiben somit aus reinem Titannitrid. Die Abscheidung wird nach 10 Minuten beendet. Die Schichtdicke der Titanboridverbindungen liegt im Bereich zwischen 10 nm und 200 nm.

Das Aufwachsen der Diamantschicht **24** kann wie in dem Beispiel 1 erfolgen, für die Beschreibung wird daher auf das obige Bespiel verwiesen.

Beispiel 3 Abscheidung einer vierteiligen Zwischenschicht auf dem Grundkörper **22** mit nachfolgendem Wachstum einer Diamantschicht **24** mit sehr dünnen stabförmigen Diamantkristallen

Die Haftvermittlungsschicht **26** aus Plättchen **31** wird nicht unmittelbar auf das Hartmetall des Grundkörpers **22** sondern auf eine Abfolge von zwei Zwischenschichten **25** aufgebracht. Auf den Grundkörper **22** wird zunächst eine Barriereschicht **28** und auf die Barriereschicht **28** eine kohlenstoffreiche Schicht aufgebracht, bevor die kohlenstofffreie Haftvermittlungsschicht **26** aufgebracht wird. Die beispielhaften Zwischenschichten **25** enthalten Titan als Basis für die Nitride und Karbide, insbesondere für die kohlenstoffhaltige Promotionsschicht **29** kann die Schicht neben Titan auch Tantal, Vanadium oder Chrom enthalten. Die Abscheidung (CVD-Verfahren) der drei Zwischenschichten **25** erfolgt vorzugsweise in einem Reaktor. Die Oberseite **23** des Grundkörpers **22** kann wie in dem ersten Beispiel vor Beginn der Abscheidung gereinigt werden.

Die Barriereschicht **28** wird aus einer Gasphase mit Titan(IV)-chlorid (TiCI4), Stickstoff (N2) und Wasserstoff (H2) abgeschieden. Titan(IV)-chlorid hat einen Anteil von 1 Vol.-% bis 4 Vol.-%, Stickstoff und Wasserstoff sind etwa in gleichen Anteilen vorhanden. Die Abscheidung findet vorzugsweise bei einer vergleichsweise niederen Temperatur im Bereich von 750°C bis 850°C, z.B. bei 800°C statt. Der Druck in der Reaktionskammer liegt zwischen 550 mbar und 650 mbar, z.B. 600 mbar. Die Barriereschicht **28** wächst kontinuierlich als glatte Schicht auf. Die Abscheidung wird fortgesetzt, bis eine 0,1 µm und 0,5 µm dicke Barriereschicht **28** erreicht ist. Bei den genannten Wachstumsbedingungen dauert dies zwischen 60 und 90 Minuten.

Die Zusammensetzung der Gasphase wird für die Promotionsschicht **29** verändert. Die Gasphase enthält nun Titan(IV)-chlorid, Methan (CH4) und Wasserstoff (H2). Methan hat einen Anteil zwischen 5 Vol.-% und 10 Vol.-%, z.B. 7,5 Vol.-%. Titan(IV)-chlorid hat einen Anteil zwischen 2 Vol.-% und 8 Vol.-%., z.B. 4,5 Vol.-%. Das Verhältnis von Methan zu Titan(IV)-chlorid liegt näherungsweise bei 10 zu 6. Wasserstoff wird in großem Überschuss angeboten. Der Druck in der Reaktionskammer wird auf einen Bereich zwischen 70 mbar und 90 mbar, z.B. 80 mbar, abgesenkt. Die Temperatur wird vorzugsweise auf 950°C bis 1050°C, z.B. 1000°C angehoben. Die Abscheidung wird solange fortgesetzt, bis eine zwischen 1 µm und 2 µm dicke Promotionsschicht **29** abgeschieden ist. Bei den genannten Wachstumsparametern sind hierfür 10 min bis 20 min zu veranschlagen.

Die Haftvermittlungsschicht **26** wird anfänglich mit einer Niederdruckabscheidung auf die Promotionsschicht **29** begonnen. Die Gasphase enthält Titan(IV)-chlorid (TiCI4), Stickstoff (N2) und Wasserstoff (H2). Die Atmosphäre ist insbesondere frei von kohlenstoffhaltigen Gasen. Titan(IV)-chlorid hat einen Volumenanteil zwischen 0,5 Vol.-% und 4 Vol.-%, vorzugsweise einen Anteil zwischen 1,0 Vol.-% und 1,5 Vol.-%. Wasserstoff hat beispielsweise einen Volumenanteil zwischen 50 Vol.-% und 90 Vol.-%, Stickstoff hat beispielsweise einen Volumenanteil zwischen 15 Vol.-% und 40 Vol.-%. Stickstoff wird in der Gasphase in großem Überschuss zu dem Titan(IV)-chlorid angeboten. In einem Beispiel sind die relativen Anteile: 240 Volumeneinheiten Wasserstoff, 50 Volumeneinheiten Stickstoff und 4 Volumeneinheiten Titan(IV)-chlorid. Der Druck in der Reaktionskammer liegt bei 550 mbar bis 650 mbar, z.B. 600 mbar. Die Temperatur wird auf hohen Niveau zwischen 950°C und 1050°C, z.B. 1000°C, gehalten. Die Abscheidung erfolgt für etwa 60 Minuten bis 120 Minuten, um eine zwischen 2 µm und 3 µm dicke Titannitridschicht zu erhalten. Die Plättchen **31** haben eine Höhe von 1 µm bis 2 µm.

Die Borierung der Plättchen **31** erfolgt mit einer geänderten Zusammensetzung der Atmosphäre, indem zu Titan(IV)-chlorid (TiCI4), Stickstoff (N2) und Wasserstoff (H2) noch Bortrichlorid (BCl3) eingeleitet wird. Das Borchlorid hat einen Anteil von 0,1 % und 0,4 %, die Gasanteile von TiCl4, N2 und H2 bleiben gegenüber der vorhergehenden Abscheidung der Plättchen **31** unverändert. Ebenso bleibt die Temperatur auf dem angehobenen Niveau. Der Druck wird auf 550 mbar bis 650 mbar, z.B. 600 mbar, erhöht. Die Plättchen **31** aus Titannitrid wachsen weiter. An den Kanten **32** der Plättchen **31** scheidet sich Kristalle aus Titanborverbindungen ab, hingegen im Wesentlich nicht auf den Seitenflächen **33** der Plättchen **31.** Die Seitenflächen **33** bleiben somit aus reinem Titannitrid. Die Abscheidung wird nach 10 Minuten beendet. Die Schichtdicke der Titanboridverbindungen liegt im Bereich zwischen 10 nm und 200 nm.

Die Diamantschicht **24** wird auf die borierten Plättchen **31** abgeschieden. Die Abscheidung der Diamantschicht **24** kann wie in dem ersten Beispiel erfolgen. Ein geändertes Verfahren ermöglicht ein schnelleres Wachstum der Diamantschicht **24** bei ähnlich guten Eigenschaften, insbesondere einer nahezu ähnlich hohen Diamantschicht **24.**

Die Haftvermittlungsschicht **26** wird mit Nanodiamantpulver bekeimt. Das Wachstum der stabförmigen Diamantkristalle erfolgt aus der Gasphase (CVD-Verfahren). Die Atmosphäre enthält Methan (CH4) und Wasserstoff (H2). Der Metangehalt liegt mit 2,5 Vol.-% bis 4,0 Vol.-%, z.B. 2,9 Vol.-%, höher als bei der Abscheidung gemäß dem ersten Verfahren. Der Druck liegt zwischen 2 mbar und 20 mbar, vorzugsweise zwischen 5 mbar bis 8 mbar. Die Abscheidungstemperatur liegt im Bereich zwischen 700°C und 850°C, z.B. bei 750°C. Der hohe Methangehalt in der Gasphase führt vermehrt sekundärer Keimbildung während des Diamantwachstums, was den Korndurchmesser quer zur Wachstumsrichtung bis in den Nanometerbereit reduziert. Trotzdem liegt teilweise noch Stängel-förmiges Wachstum vor. Es ergeben sich jedoch mehr Korngrenzen und in Folge wesentlich dünnere Stängel **34.** Die Diamantschicht **24** mit den dünnen Stängel **34** ist etwas schwächer als die aus dem ersten Beispiel, dennoch konnten bereits stabile Diamantschichten bis zu einer Höhe **36** von 23 µm realisiert werden. Die Diamantschicht **24** mit den dünnen Stängel **34** lässt sich auch auf die Haftvermittlungsschicht **26** des Beispiels 1 oder 2 abscheiden.

## Patentansprüche

1. Herstellungsverfahren für eine Schneidplatte (12), insbesondere eine Schneidplatte (12) für eine Kernbohrkrone (2), mit den Schritten:
Formen und Sintern eines Grundkörpers (22) der Schneidplatte (12) aus einem Hartmetall,
Abscheiden von ein oder mehreren Zwischenschichten (25) einschließlich einer Haftvermittlungsschicht (26) auf eine Oberseite (23) des Grundkörpers (22) mittels eines Gasabscheideverfahrens (CVD), **dadurch gekennzeichnet, dass** das Abscheiden der Haftvermittlungsschicht (26)
aus bohrhaltigen Nitriden von Übergangsmetallen die Schritte umfasst: Abscheiden von Nitriden eines oder mehrerer Übergangsmetalle aus der Gruppe IV, Gruppe V und
Gruppe VI des Periodensystems bei einer Temperatur zwischen 950°C und 1100°C zum Ausbilden einer Vielzahl zu der Oberseite (23) geneigt orientierter Plättchen (31), welche aus den Nitriden der Übergangsmetalle bestehen; und Abscheiden eines Borids und/oder Bornitrids der ein oder mehreren Übergangsmetalle;
Aufwachsen einer Diamantschicht (24) auf der Haftvermittlungsschicht (26), welches die Schritte umfasst:
Bekeimen der Haftvermittlungsschicht (26) mit Diamantstaub und
Aufwachsen von Stängel-förmigen Diamanten aus der Gasphase auf der Haftvermittlungsschicht (26).

2. Herstellungsverfahren nach Anspruch 1, **dadurch kennzeichnet, dass** die Oberseite (23) durch ein Druckluftverfahren mit einem festen Strahlmittel bearbeitet wird, bis eine gemittelte Rautiefe Rz für eine Messstrecke mit einer Länge von 800 µm wenigstens 5 µm beträgt.

3. Schneidplatte (12) mit
einem Grundkörper (22) aus einem gesinterten Hartmetall und
ein oder mehreren Zwischenschichten (25) auf einer Oberseite (23) des Grundkörpers (22), **dadurch gekennzeichnet, dass** die Zwischenschichten eine Haftvermittlungsschicht (26) aufweisen, welche aus einem borhaltigen Nitrid eines Übergangsmetalls der Gruppe IV, Gruppe V und Gruppe VI des Periodensystems besteht und eine Vielzahl zu der Oberseite (23) geneigt orientierter Plättchen (31) enthält,
einer auf der Haftvermittlungsschicht (26) aufgewachsenen Diamantschicht, wobei die Diamantschicht (24) aus zu der Oberseite (23) vertikal orientierten, Stängel-förmigen Kristallen besteht, deren Aspektverhältnis größer fünf ist.

4. Schneidplatte (12) nach Anspruch 3, **dadurch kennzeichnet, dass** die Oberseite (23) des Grundkörpers (22) eine gemittelte Rautiefe Rz für eine Messstrecke mit einer Länge von 800 µm wenigstens 5 µm beträgt.

5. Schneidplatte (12) nach Anspruch 3 oder 4, **dadurch kennzeichnet, dass** die zu der Oberseite (23) vertikalen Kristallachsen der Stängel-förmigen Kristallen (34) identisch sind

6. Schneidplatte (12) nach Anspruch 3 bis 5, **dadurch kennzeichnet, dass** die Höhe (36) der Diamantschicht (24) gleich der Höhe der Stängel-förmigen Kristalle ist.

7. Schneidplatte (12) nach Anspruch 3 bis 6, **dadurch kennzeichnet, dass** die Stängel-förmigen Kristalle einen homogenen Durchmesser aufweisen.

8. Schneidplatte (12) nach Anspruch 3 bis 7, **dadurch kennzeichnet dass** benachbarte Stängel-förmigen Kristalle über eine Korngrenze aneinander angrenzen.

## Claims

1. Production method for a cutting insert (12), in particular a cutting insert (12) for a core drill bit (2), comprising the steps of:
forming and sintering a basic body (22) of the cutting insert (12) from a hard metal, depositing one or more intermediate layers (25), including an adhesion promoting layer (26), onto an upper side (23) of the basic body (22) by means of a vapour deposition process (CVD), **characterized in that**
the depositing of the adhesion promoting layer (26) of boron-containing nitrides of transition metals comprises the steps of: depositing nitrides of one or more transition metals from the group IV, group V and group VI of the periodic table at a temperature of between 950°C and 1100°C to form a plurality of platelets (31), which are oriented such that they are inclined in relation to the upper side (23) and consist of the nitrides of the transition metals; and depositing a boride and/or boron nitride of the one or more transition metals;
growing a diamond layer (24) on the adhesion promoting layer (26), which comprises the steps of:
seeding the adhesion promoting layer (26) with diamond dust and
growing rod-shaped diamonds from the vapour phase on the adhesion promoting layer (26).

2. Production method according to Claim 1, **characterized in that** the upper side (23) is worked with a solid abrasive by a compressed-air process until an average roughness depth Rz for a measuring length of 800 µm is at least 5 µm.

3. Cutting insert (12) with
a basic body (22) of a sintered hard metal and one or more intermediate layers (25) on an upper side (23) of the basic body (22), **characterized in that** the intermediate layers have an adhesion promoting layer (26), which consists of a boron-containing nitride of a transition metal of the group IV, group V and group VI of the periodic table and contains a plurality of platelets (31) oriented such that they are inclined in relation to the upper side (23),
a diamond layer grown on the adhesion promoting layer (26), the diamond layer (24) consisting of rod-shaped crystals which are oriented vertically in relation to the upper side (23) and the aspect ratio of which is greater than five.

4. Cutting insert (12) according to Claim 3, **characterized in that** the upper side (23) of the basic body (22) has an average roughness depth Rz for a measuring length of 800 µm of at least 5 µm.

5. Cutting insert (12) according to Claim 3 or 4, **characterized in that** the vertical crystal axes, in relation to the upper side (23), of the rod-shaped crystals (34) are identical.

6. Cutting insert (12) according to Claims 3 to 5, **characterized in that** the height (36) of the diamond layer (24) is equal to the height of the rod-shaped crystals.

7. Cutting insert (12) according to Claims 3 to 6, **characterized in that** the rod-shaped crystals have a homogeneous diameter.

8. Cutting insert (12) according to Claims 3 to 7, **characterized in that** adjacent rod-shaped crystals adjoin each other over a grain boundary.

## Revendications

1. Procédé de production d'une plaquette de coupe (12), en particulier d'une plaquette de coupe (12) destinée à une couronne de carottage (2), ledit procédé comprenant les étapes suivantes :
former et fritter un corps de base (22) de la plaquette de coupe (12) à partir d'un métal dur,
déposer une ou plusieurs couches intermédiaires (25) comprenant une couche de promotion d'adhérence (26) sur une face supérieure (23) du corps de base (22) au moyen d'un procédé de dépôt en phase gazeuse (CVD),
**caractérisé en ce que**
le dépôt de la couche de promotion d'adhérence (26) en nitrures de métaux de transition contenant du bore comprenant les étapes suivantes : déposer des nitrures d'un ou plusieurs métaux de transition du groupe IV, du groupe V et du groupe VI du tableau périodique à une température comprise entre 950 °C et 1100 °C pour former un grand nombre de plaquettes (31) qui sont orientées de manière inclinée par rapport à la face supérieure (23) et qui comprennent des nitrures des métaux de transition ; et déposer un borure et/ou un nitrure de bore d'un ou plusieurs métaux de transition ;
faire croître une couche de diamant (24) sur la couche de promotion d'adhérence (26), laquelle croissance comprenant les étapes suivantes :
ensemencer la couche de promotion d'adhérence (26) avec de la poussière de diamant et
faire croître des diamants en forme de tiges à partir de la phase gazeuse sur la couche de promotion d'adhérence (26).

2. Procédé de production selon la revendication 1, **caractérisé en ce que** la face supérieure (23) est traitée avec un agent de sablage solide par un procédé à air comprimé jusqu'à ce qu'une profondeur de rugosité moyenne Rz soit d'au moins 5 µm pour une section de mesure d'une longueur de 800 µm.

3. Plaquette de coupe (12) comprenant
un corps de base (22) en métal dur fritté et
une ou plusieurs couches intermédiaires (25) sur une face supérieure (23) du corps de base (22),
**caractérisée en ce que**
les couches intermédiaires comportent une couche de promotion d'adhérence (26) qui comprend un nitrure, contenant du bore, d'un métal de transition du groupe IV, du groupe V et du groupe VI du tableau périodique et qui contient un grand nombre de plaquettes (31) orientées de manière inclinée par rapport à la face supérieure (23),
une couche de diamant dont la croissance a été effectuée sur la couche de promotion d'adhérence (26), la couche de diamant (24) comprenant des cristaux en forme de tiges qui sont orientés verticalement par rapport à la face supérieure (23) et dont le rapport d'aspect est supérieur à cinq.

4. Plaquette de coupe (12) selon la revendication 3, **caractérisée en ce que** la face supérieure (23) du corps de base (22) a une profondeur de rugosité moyenne Rz d'au moins 5 µm pour une section de mesure d'une longueur de 800 µm.

5. Plaquette de coupe (12) selon la revendication 3 ou 4, **caractérisée en ce que** les axes, verticaux par rapport à la face supérieure (23), des cristaux (34) en forme de tiges sont identiques.

6. Plaquette de coupe (12) selon les revendications 3 à 5, **caractérisée en ce que** la hauteur (36) de la couche de diamant (24) est égale à la hauteur des cristaux en forme de tiges.

7. Plaquette de coupe (12) selon la revendication 3 à 6, **caractérisée en ce que** les cristaux en forme de tiges ont un diamètre homogène.

8. Plaquette de coupe (12) selon les revendications 3 à 7, **caractérisée en ce que** des cristaux en formes de tiges qui sont voisins sont adjacents par un joint de grain.
